# EUROPEAN PATENT SPECIFICATION

(11) **EP 0 536 739 B1**
(45) Date of publication and mention of the grant of the patent: **31.05.2000**
(21) Application number: 92117180.7
(22) Date of filing: 08.10.1992
(51) Int. Cl.: H01L 23/538, G02F 1/136

(54) **Liquid crystal display device**
Flüssigkristallanzeige-Anordnung
Dispositif d'affichage à cristal liquide

(30) Priority: 09.10.1991 JP 28950991
(43) Date of publication of application: 14.04.1993
(73) Proprietor: CANON KABUSHIKI KAISHA, Tokyo (JP)
(72) Inventor: Takahashi, Masanori, c/o Canon Kabushiki Kaisha, Ohta-ku, Tokyo 146 (JP)
(74) Representative: Pellmann, Hans-Bernd, Dipl.-Ing.

(56) References cited:
- EP-A- 0 149 458
- EP-A- 0 402 106
- EP-A- 0 447 057
- PATENT ABSTRACTS OF JAPAN vol. 10, no. 248 (E-431)26 August 1966 & JP-A-61 077 346 (MATSUSHITA ELECTRIC WORKS LTD) 19 April 1986

## Description

The present invention relates to a liquid crystal display panel having an electrical packaging structure, and more particularly to a liquid crystal display panel having a packaging structure of a chip-on-panel for connecting a semiconductor chip and further particularly to an electrical packaging structure suitable for connecting a semiconductor chip to a liquid crystal display device and a liquid crystal display device having the same.

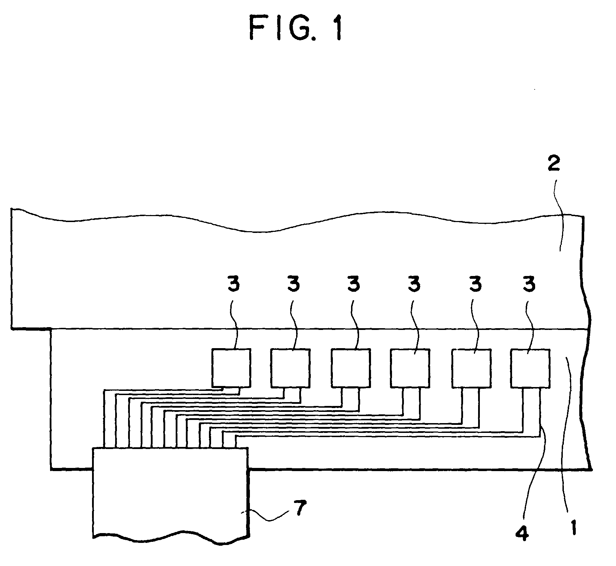

Fig. 1 shows a packing structure of a chip-on-panel for connecting a semiconductor chip 3 to a display substrate 1 which is one of glass substrates of a liquid crystal display device. All input wirings of the semiconductor chip are taken out from a connection port to an external circuit and the connection to an external circuit board is done by a flexible printed circuit board 7 or the like.

In such a structure, where a plurality of semiconductor chips 3 are to be connected, the number of input wirings 4 increases in proportion to the number of semiconductor chips 3, the number of electrode connections of the connecting port of the flexible printed circuit board 17 which electrically connects the input wirings 4 to the external circuit increases, the area required for the connection increases, and the number of wirings of the flexible printed circuit board increases.

As the number of wirings of the flexible printed circuit board increases, the problems arise in that the probability of defect in the connection of the electrically connected ports (such as break, short circuit or insufficient connection area) increases and the yield is lowered, or the probability of the break at the electrically connected point during the use of the device increases and the reliability of the device decreases.

The increase of the number of connection points leads to the increase of the manufacturing cost, which frequently affects to the compactness of the flexible printed circuit board and the compactness of the device.

Furthermore, EP-A-0 402 106 discloses a display device with a driving circuit arranged along the periphery of a substrate. However, the primary concern of the invention described in this document resides in the provision of a display device safe from high temperatures generated in driving elements and a display device free from malfunction caused by light. To this end, the disclosure focuses on specific arrangements of light-shielding heat releasers.

However, a specific wiring arrangement is not at all disclosed.

Document EP-A-0 149 458 discloses a liquid crystal display unit including a display panel having a plurality of terminals, a plurality of flexible films made of electrically non-conductive material and an LSI chip carried on each flexible film. A plurality of electrodes are deposited on the film, and films are provided in association with the display panel so as to electrically connect the LSI chips with terminals.

However, due to the provision of a flexible carrier to be inserted between the flexible film and the panel, there exists a drawback such that the entire device is increased in thickness and size. Moreover, apart from an additional manufacturing step of inserting the carrier, an additional connection step is required. This means, that the connection of pads requires another processing, e.g. soldering/bonding than the connection of the LSI chips of film carrier type to the electrodes, which could be assumed to be effected, e.g. by wire bonding. Thus, the arrangement known from this prior art document seems to suffer from a drawback such that an additional manufacturing step for electrical connection has to be provided for, thereby rendering the manufacturing as such more expensive.

Consequently, it is an object of the present invention to solve the above problems, i.e. to provide a liquid crystal display panel by means of which the manufacturing costs can be reduced and by means of which the size of the entire device can be reduced.

More over, the present invention aims to provide a liquid crystal display panel having a reduced number of electrical connections, reduced area required for the connection and reduced number of wirings of the flexible printed circuit board.

It is another aim of the present invention to provide a liquid crystal display panel which reduces the manufacturing cost, reduces the area required for the wiring connection and reduces the size of the entire device.

It is a further aim of the present invention to provide a liquid crystal display device having an electrical packaging structure of a chip-on-panel for connecting a plurality of driving semiconductor chips to a display substrate of the liquid crystal display device, which reduces the number of connecting electrodes of the display substrate and the external circuit, reduces the area required for the connection and reduces the number of wirings of the flexible printed circuit board used for the connection of the display substrate and the external circuit.

The above object and aims of the present invention are achieved by a liquid crystal display panel as defined in claim 1.

Advantageous further developments are as set out in the dependent claims.
Fig. 1 shows a schematic plan view of a prior art device,
Fig. 2 shows a schematic plan view of a liquid crystal display panel having a packaging structure in accordance with one preferred embodiment of the present invention, and
Fig. 3 shows a conceptual view of a distributing semiconductor chip for distributing input wirings to driving semiconductor chips.

A preferred embodiment of the present invention is now explained with reference to the drawings.

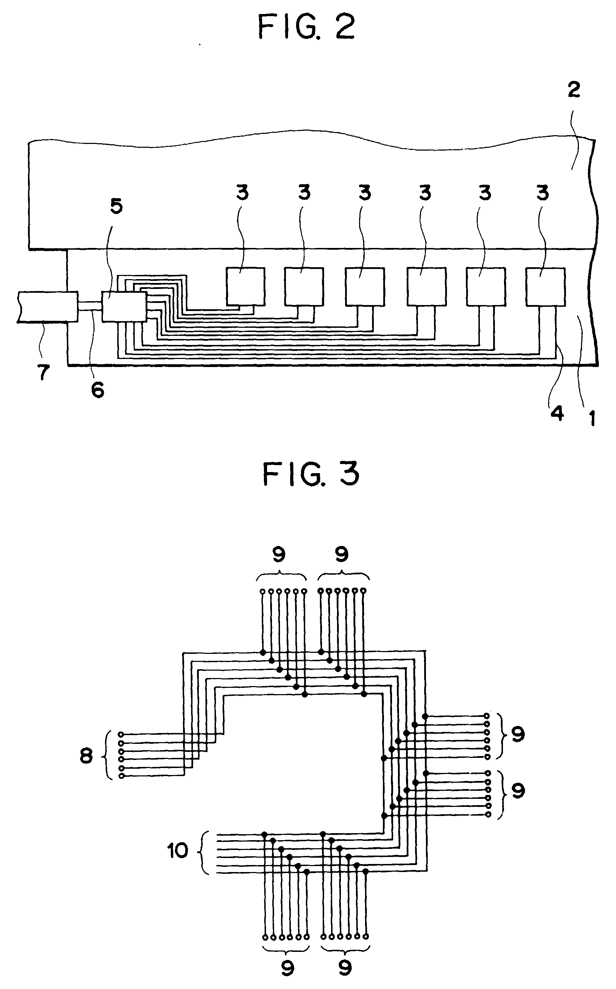

Fig. 2 shows a schematic plan view of a packaging structure in the present embodiment. In the present embodiment, the packaging structure is applied to a liquid crystal display device which uses a ferroelectric liquid crystal.

In Fig. 2, numerals 1 and 2 denote first and second glass substrates which face each other with a liquid crystal layer (not shown) interposed therebetween. A plurality of semiconductor chips 3 for driving the liquid crystal display device are face-down bonded to the glass substrate 1. Numeral 4 denotes input wirings to the semiconductor chips 3. More wirings are used in an actual liquid crystal display device. Numeral 5 denotes a distributing semiconductor chip having internal wirings for distributing the input wirings to the semiconductor chips 3. It is face-down bonded to the glass substrate 1. The input wirings 4 are wired from the chip 5 to the semiconductor chips 3. Numeral 6 denotes input wirings to the chip 5. They are distributed to the input wirings 4 through the chip 5. Numeral 7 denotes a flexible printed circuit board for connecting an external circuit and the liquid crystal display device. They are connected by soldering or an anisotropy conduction bonding film or the like.

In order to solve the above problems, in the packaging structure of the chip-on-panel of the present invention which connects a plurality of driving semiconductor chips to the display substrate of the liquid crystal display device, the input wirings on the display substrate to the semiconductor chips are distributed through the chip 5 connected to the display substrate.

In accordance with the present invention, since the input wirings on the display substrate to the driving semiconductor chips are wired through the chip 5 having the internal wiring, the number of connection electrodes of the display substrate and the external circuit is reduced.

The chip 5 may be treated equally to the driving semiconductor chips of the liquid crystal display device.

The distributing semiconductor chip 5 is now explained in detail.

Fig. 3 shows a conceptual view of the chip 5. In Fig. 3, numeral 8 denotes input connection electrodes which are distributed or so-called matrix-connected to connection electrodes 9 through common wirings 10 representing the internal wiring.

Since a semiconductor chip 5 having the wirings formed by the semiconductor process is used, the semiconductor chip may be connected to the glass substrate 1 by the same means as that for connecting the driving semiconductor chips 3 to the glass substrate 1. The only requirement is that the semiconductor chip has an internal wiring structure or common wiring configuration, respectively, and it is not necessary that the connection to the devices in the chip have been made for signal processing purpose.

The semiconductor chips 3 and the chip 5 may be connected to the glass substrate 1 by grounding the connection electrodes on the glass substrate 1, spraying charged conductive fine particles onto the glass substrate 1, depositing the conductive fine particles to the connection electrodes of the glass substrate 1, and connecting the semiconductor chips 3 and the wiring board 5 by an insulative bonding material.

Alternatively, the semiconductor chips 3 and the chip 5 may be connected to the glass substrate 1 by face-up bonding the semiconductor chips 3 and the chip 5 the glass substrate 1 and connecting them by wire bonding.

The above objects can be achieved by using the packaging structure of the present invention.

Since the input wirings on the display substrate to the plurality of driving semiconductor chips are wired through the chip having the internal wiring or common wiring configuration, respectively, the number of connection electrodes of the display substrate and the external circuit may be reduced, the area required for the connections may be reduced, the number of wirings of the flexible printed circuit board used for the connection of the display substrate and the external circuit may be reduced, and the cost may be reduced.

The semiconductor chip 5 may be connected to the glass substrate by the same means as that for connecting the driving semiconductor chips 3 of the liquid crystal display device to the glass substrate.

A highly reliable electrical packaging structure and a liquid crystal display device having the structure are provided by the present invention.

Since higher finess and higher drive speed are required for the liquid crystal display device (particularly that which uses ferroelectric liquid crystal which is suitable for high finess), there is a trend of increase of the number of semiconductor chips. The adoption of the electrical packaging structure of the present invention not only contributes to the compactness and high reliability of the device but also significantly contributes to the improvement of image quality.

## Claims

1. A liquid crystal display panel comprising first and second substrates **(1, 2)** between which a liquid crystal is disposed, and having on an exposed area of one of the substrates (1) a plurality of driving semiconductor chips **(3)**
**characterized by**
first input wirings **(4)** connected to respective ones of said plurality of semiconductor chips **(3)** and located on said exposed area of said one of said substrates **(1)**, and
a further semiconductor chip **(5)** is located on said exposed area of said one of the substrates **(1)**, said further semiconductor chip **(5)** having
input connection electrodes **(8)** connected to second input wirings **(6)** for connection to external circuitry and connection electrodes **(9)** connected to said first input wirings **(4)**, and
a common wiring configuration **(10)** formed within said further semiconductor chip **(5)** and being in the form of a bus-type configuration connecting said input connection electrodes **(8)** to said connection electrodes **(9).**

2. A liquid crystal display panel according to claim 1, wherein said liquid crystal display panel uses a ferroelectric liquid crystal.

## Patentansprüche

1. Flüssigkristall-Anzeigetafel mit ersten und zweiten Substraten (1, 2), zwischen denen ein Flüssigkristall angeordnet ist, und die an einem freiliegenden Bereich von einem der Substrate (1) eine Vielzahl von Ansteuerungs-Halbleiterchips (3) hat
**gekennzeichnet durch**
erste Eingangsleitungen (4), die mit jeweiligen der Vielzahl von Hamleiterchips (3) verbunden sind und sich auf dem freiliegenden Bereich des einen der Substrate (1) befinden, und
einen weiteren Halbleiterchip (5), der sich auf dem freiliegenden Bereich des einen der Substrate (1) befindet, wobei der weitere Halbleiterchip (5) aufweist
Eingangsverbindungselektroden (8), die mit zweiten Eingangsleitungen (6) zur Verbindung mit externen Schaltkreisen und mit Verbindungselektroden (9), die mit den ersten Eingangsleitungen (4) verbunden sind, verbunden sind, und
eine gemeinsame Leitungskonfiguration (10), die innerhalb des weiteren Halbleiterchips (5) ausgebildet ist und in der Form einer Bus-artigen Konfiguration vorliegt, welche die Eingangsverbindungselektroden (8) mit den Verbindungselektroden (9) verbindet.

2. Flüssigkristall-Anzeigetafel nach Anspruch 1, wobei die Flüssigkristall-Anzeigetafel einen ferroelektrischen Flüssigkristall verwendet.

## Revendications

1. Panneau d'affichage à cristal liquide comportant des premier et second substrats (1, 2) entre lesquels un cristal liquide est disposé, et ayant, sur une zone exposée de l'un des substrats (1), plusieurs puces semiconductrices d'attaque (3),
caractérisé par
des premiers câbles d'entrée (4) connectés à certaines, respectives, de ladite pluralité de puces semi-conductrices (3) et placés sur ladite zone exposée dudit premier desdits substrats (1), et
une autre puce semiconductrice (5) est placée sur ladite zone exposée dudit premier des substrats (1), ladite autre puce semiconductrice (5) ayant
des électrodes (8) de connexion d'entrée connectées à des seconds câblages d'entrée (6) pour une connexion à des circuits extérieurs et des électrodes (9) de connexion connectées auxdits premiers câblages d'entrée (4), et
une configuration de câblage commun (10) formée à l'intérieur de ladite autre puce semiconductrice (5) et se présentant sous la forme d'une configuration du type bus connectant lesdites électrodes (8) de connexion d'entrée auxdites électrodes (9) de connexion.

2. Panneau d'affichage à cristal liquide selon la revendication 1, dans lequel ledit panneau d'affichage à cristal liquide utilise un cristal iquide ferro-électrique.
